# FASCICULE DE BREVET EUROPEEN

(11) **EP 3 482 421 B1**
(45) Date de publication et mention de la délivrance du brevet: **13.05.2020**
(21) Numéro de dépôt: 17737264.6
(22) Date de dépôt: 07.07.2017
(51) Int. Cl.: H01L 31/109

(54) **DÉTECTEUR DE RAYONNEMENT ET IMAGEUR ASSOCIÉ**
STRAHLUNGSDETEKTOR UND ZUGEHÖRIGER BILDGEBER
RADIATION DETECTOR AND ASSOCIATED IMAGER

(30) Priorité: 08.07.2016 FR 1601065
(43) Date de publication de la demande: 15.05.2019
(73) Titulaire: Thales, 92400 Courbevoie (FR); Commissariat à l'Energie Atomique et aux Energies Alternatives, 75015 Paris (FR)
(72) Inventeur: EVIRGEN, Axel, 91767 PALAISEAU CEDEX (FR); REVERCHON, Jean-Luc, 91767 PALAISEAU CEDEX (FR)
(74) Mandataire: Lavoix
(86) Numéro de dépôt international: PCT/EP2017/067129
(87) Numéro de publication internationale: WO 2018/007603

(56) Documents cités:
- US-A- 4 254 429
- US-A1- 2013 313 608

## Description

La présente invention concerne un détecteur de rayonnement et un imageur comprenant une pluralité de tels détecteurs de rayonnement.

De nombreux types de détecteurs de rayonnement comportent un ensemble de couches semi-conductrices superposées, comprenant une couche absorbante dont la bande interdite d'énergie (ou « gap ») est adaptée pour que la couche absorbante absorbe un rayonnement, générant ainsi une paire électron-trou. La structure de bande de tels détecteurs est prévue pour que l'électron et le trou ainsi générés soient séparés l'un de l'autre et qu'un courant électrique apparaisse donc lorsque le rayonnement est absorbé. Il est par exemple connu du document FR 2 800 201 A1 un détecteur de rayonnement du type précité. Le document US2013/0313608 décrit un Détecteur à base de matériaux III-V.

Cependant, d'autres mécanismes de génération d'un courant sont également susceptibles d'exister dans une telle structure, donnant naissance à un courant électrique appelé courant d'obscurité, qui n'est pas corrélé à l'absorption du rayonnement. Le courant d'obscurité limite alors la sensibilité du détecteur, puisque le signal électrique fourni par le détecteur n'est plus uniquement représentatif du rayonnement détecté.

De tels détecteurs sont utilisés pour de nombreuses applications, allant des capteurs photographiques détectant les rayonnements visibles aux imageurs fonctionnant dans la gamme infrarouge. En particulier, les détecteurs infrarouges sont particulièrement sensibles aux courants d'obscurité, qui ne sont pas négligeables dans tous les cas devant les courants générés par le rayonnement.

Afin d'améliorer la sensibilité des détecteurs infrarouge de haute performance, ceux-ci sont en général refroidis à basse température, par exemple autour de 80 Kelvin (K) ou moins. Cependant, les systèmes de cryogénie utilisés sont gourmands en énergie, lourds et encombrants, ce qui est problématique pour de nombreuses utilisations. De plus, lors de l'initialisation du détecteur, l'atteinte de la température visée ralentit l'utilisation des détecteurs.

En outre, le courant d'obscurité comporte des composantes de génération-recombinaison et de diffusion avec différentes lois d'activation thermique. En particulier, le courant d'obscurité lié aux phénomènes de génération-recombinaison est prédominant à basse température.

Il existe donc un besoin pour un détecteur de rayonnement qui présente une meilleure sensibilité que les détecteurs existants, en particulier à une température supérieure à 80 K. A cet effet, il est proposé un détecteur de rayonnement tel que défini par l'objet de la revendication 1.

Suivant des modes de réalisation particuliers, le détecteur comprend une ou plusieurs des caractéristiques suivantes, prises isolément ou suivant toutes les combinaisons techniquement possibles :
- la couche de transition présente un dopage du deuxième type.
- une densité volumique de dopants est définie pour chacune de la couche absorbante et de la couche de charges écran, la densité volumique de dopants de la couche absorbante étant strictement inférieure à la densité volumique de dopants de la couche de charges écran.
- la deuxième densité volumique de dopants est comprise entre 10¹⁶ et 10¹⁷ atomes par centimètres cube.
- l'empilement comprend en outre une deuxième couche fenêtre réalisée en un cinquième matériau semi-conducteur présentant une cinquième valeur de gap et une couche intermédiaire réalisée en un sixième matériau semi-conducteur présentant une sixième valeur de gap, la couche absorbante étant délimitée selon la direction d'empilement par la couche de charges écran et la couche intermédiaire, la couche intermédiaire étant délimitée selon la direction d'empilement par la couche absorbante et par la deuxième couche fenêtre, la cinquième valeur de gap étant strictement supérieure à la première valeur de gap et la sixième valeur de gap étant comprise entre la cinquième valeur de gap et la première valeur de gap.
- la couche intermédiaire présente un dopage du premier type, une densité volumique de dopants étant définie pour la couche intermédiaire, la densité volumique de dopants de la couche intermédiaire étant supérieure ou égale à la densité volumique de dopants de la couche absorbante.
- le premier matériau, le deuxième matériau, le troisième matériau et le quatrième matériau sont des matériaux semi-conducteurs à base d'éléments des colonnes IIIA et VA du tableau périodique des éléments.
- la première couche fenêtre comporte une première portion présentant un dopage du deuxième type et au moins une deuxième portion présentant un dopage du premier type, la deuxième portion séparant chaque première portion de chaque autre première portion et chaque première portion étant entourée par la deuxième portion dans un plan perpendiculaire à la direction d'empilement.

D'autres caractéristiques et avantages de l'invention apparaîtront également à la lecture de la description qui va suivre, donnée uniquement à titre d'exemple non limitatif et faite en référence aux dessins annexés, sur lesquels :
- la figure 1 est une vue schématique en coupe d'un imageur comprenant une pluralité de détecteurs de rayonnement,
- la figure 2 est un diagramme de principe des bandes d'énergie du détecteur de la figure 1, pris selon la ligne II-II en considérant les bandes d'énergies des différents matériaux comme plates,
- la figure 3 est un diagramme des bandes d'énergie selon la ligne II-II d'un exemple de détecteur obtenu par simulation numérique,
- la figure 4 est un diagramme de principe des bandes d'énergie du détecteur de la figure 1, pris selon la ligne III-III en considérant les bandes d'énergies des différents matériaux comme plates,
- la figure 5 est un diagramme des bandes d'énergie selon la ligne III-III d'un exemple de détecteur obtenu par simulation numérique.

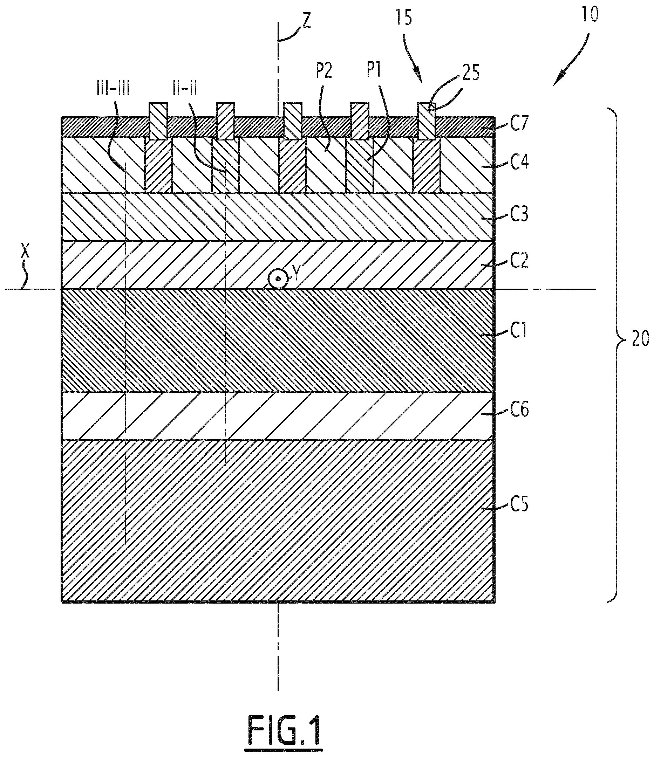

Pour la suite de la description, il est défini une direction longitudinale. Il est également défini une direction d'empilement et une direction transversale. La direction d'empilement est une direction perpendiculaire à la direction longitudinale et contenue dans un plan transverse par rapport à la direction longitudinale. La direction d'empilement correspond à une direction générale de propagation de la lumière. La direction transversale est perpendiculaire à la direction longitudinale et à la direction d'empilement. Les directions longitudinale, d'empilement et transversale sont respectivement symbolisées par l'axe X, un axe Z et un axe Y sur la figure 1.

Un imageur 10 est représenté sur la figure 1.

L'imageur 10 comporte une pluralité de détecteurs 15 de rayonnement et un circuit de lecture. Par exemple, l'imageur 10 comporte une matrice bidimensionnelle de détecteurs de rayonnement 15.

L'imageur 10 est configuré pour générer une image Im comprenant une pluralité de pixels. Un pixel est l'unité de base permettant de mesurer la définition d'une image numérique matricielle. Le mot pixel provient de la locution anglaise *picture element,* qui signifie « élément d'image ».

Chaque détecteur de rayonnement 15 est identique aux autres détecteurs de rayonnement 15. Un exemple de détecteur de rayonnement 15 va être décrit dans ce qui suit.

Chaque détecteur de rayonnement 15 correspond à un pixel de l'image Im. En particulier, chaque détecteur de rayonnement 15 est propre à générer un signal électrique S lorsque le détecteur de rayonnement 15 absorbe un rayonnement IR. Le signal électrique S est destiné à permettre à l'imageur 10, de générer le pixel correspondant.

Chaque détecteur de rayonnement 15 présente une gamme spectrale de fonctionnement. La gamme spectrale de fonctionnement du détecteur de rayonnement 15 appartient à l'une des gammes spectrales suivantes : l'infrarouge, l'infrarouge proche, l'infrarouge moyen et l'infrarouge lointain.

Une onde électromagnétique OE appartient à la gamme infrarouge si une longueur d'onde de l'onde OE est comprise au sens large entre 780 nanomètres (nm) et 25 micromètres (µm). Une onde électromagnétique appartient à la gamme infrarouge proche si la longueur d'onde de l'onde est comprise au sens large entre 780 nm et 3 µm.

Une onde appartient à la gamme infrarouge moyen si la longueur d'onde de l'onde OE est comprise au sens large entre 3 µm et 8 µm.

Une onde appartient à la gamme infrarouge lointain si la longueur d'onde de l'onde OE est comprise au sens large entre 8 µm et 15 µm.

En variante, la gamme spectrale de fonctionnement appartient à la gamme visible. La gamme visible est composée des ondes électromagnétiques OE dont la longueur d'onde est comprise au sens large entre 400 nm et 800 nm.

Chaque détecteur de rayonnement 15 comprend un empilement 20 de couches superposées le long de la direction d'empilement Z, une première électrode 25 et une deuxième électrode. Par l'expression « couches superposées », il est entendu que les couches sont disposées les unes sur les autres le long de la direction d'empilement Z.

L'empilement 20 comprend donc une succession de couches dans la direction d'empilement Z. Chaque couche de l'empilement 20 est donc définie par une épaisseur selon la direction d'empilement Z.

L'empilement 20 s'étend, en outre, dans la direction longitudinale X et dans la direction transversale Y puisque chaque couche de l'empilement 20 est définie par une longueur selon la direction longitudinale X et une largeur selon la direction transversale Y.

L'empilement 20 de couches superposées comprend successivement, le long de la direction d'empilement Z, une couche absorbante C1, une couche de charges écran C2, une couche de transition C3, et une première couche fenêtre C4.

Selon l'exemple de la figure 1, chaque empilement 20 comporte, en outre, une deuxième couche fenêtre C5, une couche intermédiaire C6, et une couche de passivation C7.

La couche absorbante C1 est propre à absorber au moins en partie le rayonnement IR.

La couche absorbante C1 est commune à tous les éléments détecteurs 15 de l'imageur 10.

La couche absorbante C1 est réalisée dans un premier matériau semi-conducteur M1 présentant une première valeur de gap G1.

Il est entendu par « valeur de gap » d'un matériau la valeur de la largeur de la bande interdite entre la bande de valence et la bande de conduction dans le matériau. La valeur de gap d'un matériau est, par exemple, exprimée en électron-volts (eV).

La bande de valence est définie comme étant, parmi les bandes d'énergie permises pour un électron dans le matériau considéré, la bande qui présente l'énergie la plus haute tout en étant remplie complètement à une température inférieure ou égale à 20 K.

Un premier niveau d'énergie est défini pour chaque bande de valence. Le premier niveau d'énergie est le niveau d'énergie le plus élevé de la bande de valence.

La bande de conduction est définie comme étant, parmi les bandes d'énergie permises pour un électron dans le matériau, la bande qui présente l'énergie la plus basse tout en n'étant pas remplie à une température inférieure ou égale à 20 K.

Un deuxième niveau d'énergie est défini pour chaque bande de conduction. Le deuxième niveau d'énergie est le niveau d'énergie le plus bas de la bande de conduction.

Ainsi, chaque valeur de gap est mesurée entre le premier niveau d'énergie et le deuxième niveau d'énergie du matériau considéré.

Il est entendu par « matériau semi-conducteur » un matériau présentant une valeur de gap strictement supérieure à zéro et inférieure ou égale à 6.5 eV.

Le premier matériau M1 est un matériau composé ou non.

Un matériau composé est un assemblage d'au moins deux éléments.

Chaque élément formant le premier matériau M1 appartient à l'une des colonnes de la classification périodique parmi les colonnes suivantes : IIb, IIIa, IVa, Va et Via.

La classification périodique utilisée est la classification par numéro atomique croissant établie par Moseley au début du XX^{ème} siècle.

Le groupe IIb de la classification périodique est aussi appelé groupe XII. Le groupe II comprend, notamment, le zinc (Zn), le cadmium (Cd) et le mercure (Hg).

Le groupe IIIa de la classification périodique est aussi appelé groupe XIII. Le groupe IIIa correspond au groupe du bore et comprend, notamment, le bore (B), l'aluminium (Al), le gallium (Ga) et l'indium (In).

Le groupe IVa de la classification périodique est aussi appelé groupe XIV. Le groupe IVa comprend, notamment, le silicium (Si) et le germanium (Ge).

Le groupe Va de la classification périodique est aussi appelé groupe XV ou famille de l'azote. Le groupe Va comprend, notamment, l'azote (N), le phosphore (P), l'arsenic (As) et l'antimoine (Sb).

Le groupe Via de la classification périodique est aussi appelé groupe XVI. Le groupe Via comprend, notamment, l'oxygène (O), le soufre (S) et le sélénium (Se).

Avantageusement, les matériaux des colonnes IIIa et IIa peuvent respectivement être associés à des matériaux des colonnes Va et Via pour la réalisation d'hétérostructures pour photodétecteurs. On parle alors d'alliages II-VI ou III-V.

Le premier matériau M1 est un matériau à base d'éléments des colonnes IIIa et Va du tableau périodique des éléments. Le premier matériau M1 est, par exemple, l'arseniure-antimoniure d'indium InAsSb.

La couche absorbante C1 présente une première épaisseur e1 selon la direction d'empilement Z.

La couche absorbante C1 est planaire. Cela signifie que la première épaisseur e1 est uniforme, à 10% près. Il est entendu par l'expression « épaisseur uniforme » d'une couche que l'épaisseur de la couche est identique en tous points de la couche.

La couche absorbante C1 présente, en outre, une largeur selon la direction longitudinale X et une longueur selon la direction transversale Y. Il est également entendu par le terme « couche planaire » que la longueur et la largeur sont, chacune, supérieures strictement à dix fois l'épaisseur de la couche.

La couche absorbante C1 est perpendiculaire à la direction d'empilement Z.

La couche absorbante C1 est délimitée, selon la direction d'empilement Z, par la couche de charges écran C2 et par la couche intermédiaire C6.

La première épaisseur e1 est comprise entre 100 nm et 10 µm.

La couche absorbante C1 présente un dopage d'un premier type.

Le dopage est défini comme étant la présence, dans un matériau, d'impuretés apportant des porteurs de charge libres. Les impuretés sont, par exemple, des atomes d'un élément qui n'est pas présent naturellement dans le matériau.

Lorsque la présence des impuretés augmente la densité volumique de trous présents dans le matériau par rapport au matériau non dopé, le dopage est de type p. Par exemple, une couche d'InAsSb est dopée p par l'adjonction d'atomes de beryllium (Be), de cadmium (Cd) ou de zinc (Zn).

Lorsque la présence des impuretés augmente la densité volumique d'électrons libres présents dans le matériau par rapport au matériau non dopé, le dopage est de type n. Par exemple, une couche d'InAsSb est dopée n par l'adjonction d'atomes de tellure (Te) ou de silicium (Si).

Le premier type de dopage est choisi parmi le dopage de type n et le dopage de type p. Par exemple, le premier type de dopage est le dopage de type n.

Une première densité volumique de dopants d1 est définie pour la couche absorbante C1. Une densité volumique de dopants est définie, pour un matériau, comme étant le nombre d'atomes dopants par unité de volume.

La première densité volumique de dopants d1 est uniforme. Cela signifie que, si la première densité volumique de dopants d1 est mesurée, la valeur mesurée ne dépend pas de l'emplacement dans la couche absorbante C1 où la mesure est effectuée.

Par exemple, la première densité volumique de dopants d1 est mesurée par spectrométrie de masse à ionisation secondaire (également connu sous l'acronyme « SIMS » d'après le terme anglais « secondary ion mass spectrometry »). Le SIMS est un procédé d'analyse de surface qui consiste à bombarder la surface de l'échantillon à analyser avec un faisceau d'ions.

La première densité volumique de dopants d1 est comprise entre 10¹⁴ et 10¹⁸ atomes par centimètres cube (/cm³). En variante, la première densité volumique de dopants d1 présente un gradient selon la direction d'empilement Z.

Il est entendu par « gradient selon la direction d'empilement Z » une variation monotone de la quantité considérée selon la direction considérée. Par exemple, la première densité volumique de dopants d1 augmente continûment selon la direction d'empilement Z à partir de la couche de charges écran C2 jusqu'à la couche intermédiaire C6, ou vice-versa.

La couche de charge écrans C2 est commune à tous les éléments détecteurs 15 de l'imageur 10.

La couche de charges écran C2 sépare la couche absorbante C1 de la couche de transition C3 selon la direction d'empilement Z. En particulier, la couche de charges écran C2 est délimitée, selon la direction d'empilement Z, par la couche absorbante C1 et par la couche de transition C3.

La couche de charges écran C2 est réalisée en un deuxième matériau M2.

Le deuxième matériau M2 est un matériau semi-conducteur. Le deuxième matériau M2 présente une deuxième valeur de gap G2. La deuxième valeur de gap G2 est supérieure à la première valeur de gap G1. Par exemple, la deuxième valeur de gap G2 est strictement supérieure à la première valeur de gap G1.

Le deuxième matériau M2 est un matériau à base d'éléments des colonnes IIIa et Va du tableau périodique des éléments.

Le deuxième matériau M2 est un matériau quaternaire. En particulier, le deuxième matériau M2 est constitué des éléments constituant également le premier matériau M1 et d'au moins un autre élément. Par exemple, lorsque le premier matériau M1 est InAsSb, le deuxième matériau M2 est InAlAsSb. En variante, le deuxième matériau M2 est InGaAsSb. En variante, le deuxième matériau M2 peut présenter un gradient de composition le long de la direction Z.

La couche de charges écran C2 présente un dopage du premier type.

Une deuxième densité volumique de dopants d2 est définie pour la couche de charges écran C2. Par exemple, la deuxième densité volumique de dopants d2 est strictement supérieure à la première densité volumique de dopants d1.

La deuxième densité volumique de dopants d2 est comprise entre 10¹⁴ atomes/cm³ et 10¹⁷ atomes/cm³.

La couche de charges écran C2 est planaire. La couche de charges écran C2 est perpendiculaire à la direction d'empilement Z.

La couche de charges écran C2 présente une deuxième épaisseur e2. La deuxième épaisseur e2 est comprise entre 20 nm et 1 µm.

La couche de charges écran C2 forme une interface de type II avec la couche absorbante C1.

Une interface de type II entre deux matériaux est définie comme étant une interface dans laquelle une différence entre les deux premiers niveaux d'énergie des deux matériaux considérés présente le même signe qu'une différence entre les deux deuxièmes niveaux d'énergie des deux matériaux considérés. En d'autres termes, le matériau dont la bande de valence est la plus haute en énergie présente également la bande de conduction la plus haute en énergie parmi les deux matériaux de l'interface.

En variante, la couche de charges écran C2 et la couche absorbante C1 ne forment pas de discontinuité dans la bande des porteurs de charge minoritaires. Les porteurs de charge minoritaires considérés sont les porteurs de charge minoritaires dans la couche absorbante C1.

Il est entendu par « porteur de charge minoritaire » un porteur de charge dont la densité volumique n'est pas augmentée par le dopage présent dans le matériau considéré. Par exemple, lorsque le matériau est dopé p, les porteurs de charge minoritaires sont les électrons. Lorsque le matériau est dopé n, les porteurs de charge minoritaires sont les trous.

Il est entendu par « discontinuité » un écart d'énergie supérieur à trois fois kT entre les bandes de conduction du premier matériau M1 et du deuxième matériau M2 ou entre les bandes de valence du premier matériau M1 et du deuxième matériau M2, T étant la température de fonctionnement de l'imageur 10 et k étant la constante de Boltzmann. Il est entendu par « bande des porteurs de charge minoritaires » pour un matériau la bande de conduction lorsque le matériau est dopé p et la bande de valence lorsque le matériau est dopé n.

En d'autres termes, la couche de charges écran C2 et la couche absorbante C1 ne présentent pas de barrière d'énergie à un mouvement depuis la couche absorbante C1 jusqu'à la couche de charges écran C2 des porteurs de charge minoritaires dans la couche absorbante C1.

La couche de transition C3 est commune à tous les éléments détecteurs 15 de l'imageur 10.

La couche de transition C3 est délimitée selon la direction d'empilement Z par la couche de charges écran C2 et par la première couche fenêtre C4. En particulier, la couche de transition C3 sépare la couche de charges écran C2 de la première couche fenêtre C4 selon la direction d'empilement Z.

La couche de transition C3 a pour but d'ajuster l'offset de bande pour les porteurs de charge minoritaires. En particulier, la couche de transition est configurée pour ne pas former une barrière à un mouvement des porteurs de charge minoritaires depuis la couche de charges écran jusqu'à la première couche fenêtre C4.

La couche de transition C3 est configurée pour ne pas être traversée selon la direction d'empilement Z par effet tunnel par les porteurs de charges majoritaires dans la couche absorbante C1. Les porteurs de charge majoritaires sont les porteurs de charge complémentaire des porteurs minoritaires, c'est-à-dire les trous lorsque les porteurs minoritaires sont les électrons et vice-versa.

La couche de transition C3 présente un dopage d'un deuxième type. Le deuxième type de dopage est différent du premier type de dopage. Le deuxième type de dopage est choisi parmi le dopage de type p et le dopage de type n.

En variante, la couche de transition C3 présente un dopage du premier type.

Une troisième densité volumique de dopants d3 est définie pour la couche de transition C3.

La troisième densité volumique de dopants d3 est, par exemple, comprise entre 10¹⁵ atomes/cm³ et 10¹⁸ atomes/cm³.

La couche de transition C3 est réalisée en un troisième matériau M3. Le troisième matériau M3 est un matériau semi-conducteur.

Le troisième matériau M3 est un matériau semi-conducteur. Le troisième matériau M3 présente une troisième valeur de gap G3.

La troisième valeur de gap G3 est supérieure strictement à la première valeur de gap G1. Par exemple, la troisième valeur de gap G3 est supérieure ou égale à la deuxième valeur de gap G2.

Le troisième matériau M3 est un matériau à base d'éléments des colonnes IIIa et Va du tableau périodique des éléments. Par exemple, le matériau M3 est l'antimoniure de gallium GaSb. En variante, le troisième matériau M3 est l'arséniure-antimoniure d'aluminium et de gallium AIGaAsSb. Selon d'autres variantes, le troisième matériau M3 est choisi parmi l'arséniure-antimoniure d'indium et de gallium InGaAsSb, et l'arséniure-antimoniure d'indium et de d'aluminium InAlAsSb.

En variante, le matériau M3 peut présenter un gradient de composition selon la direction Z. Le troisième matériau M3 est choisi pour que la couche de charges écran C2 et la couche de transition C3 forment une interface de type II.

En variante, le troisième matériau M3 est choisi pour que la couche de charges écran C2 et la couche de transition C3 ne forment pas de discontinuité dans la bande des porteurs de charge minoritaire. Les porteurs de charges minoritaires considérés sont les porteurs de charges minoritaires dans la couche absorbante C1. En particulier, le troisième matériau M3 est choisi pour que la couche de charges écran C2 et la couche de transition C3 ne présentent pas de barrière d'énergie au mouvement des porteurs minoritaires depuis la couche de charges écran C2 jusqu'à la couche de transition C3 selon la direction d'empilement Z.

Le troisième matériau M3 est choisi pour que la première couche fenêtre C4 et la couche de transition C3 ne forment pas de discontinuité dans la bande des porteurs de charge minoritaire. Les porteurs de charges minoritaires considérés sont les porteurs de charges minoritaires dans la couche absorbante C1. En particulier, le troisième matériau M3 est choisi pour que la première couche fenêtre C4 et la couche de transition C3 ne présentent pas de barrière d'énergie au mouvement des porteurs minoritaires vers la première couche fenêtre C4 depuis la couche de transition C3 selon la direction d'empilement Z.

La première couche fenêtre C4 est transparente au rayonnement IR.

La première couche fenêtre C4 est commune à tous les éléments détecteurs 15 de l'imageur 10.

La première couche fenêtre C4 sépare la couche de transition C3 de la couche de passivation C7 selon la direction d'empilement Z. En particulier, la première couche fenêtre C4 est délimitée, selon la direction d'empilement Z, par la couche de transition C3 et par la couche de passivation C7.

La première couche fenêtre C4 est réalisée en un quatrième matériau M4.

Le quatrième matériau M4 est un matériau semi-conducteur. Le quatrième matériau M4 présente une quatrième valeur de gap G4.

La quatrième valeur de gap G4 est supérieure strictement à la première valeur de gap G1. Le quatrième matériau M4 est un alliage d'éléments des colonnes IIIa et Va du tableau périodique des éléments. Par exemple, le quatrième matériau M4 est l'antimoniure de gallium GaSb.

La quatrième valeur de gap G4 est, par exemple, supérieure ou égale à la troisième valeur de gap G3.

En variante, la quatrième valeur de gap G4 est strictement inférieure à la troisième valeur de gap G3.

La première couche fenêtre C4 est planaire. La première couche fenêtre C4 est perpendiculaire à la direction d'empilement Z.

La première couche fenêtre C4 présente une quatrième épaisseur e4. La quatrième épaisseur e4 est comprise entre 50 nm et 1 µm.

La première couche fenêtre C4 comporte une première portion P1 et une deuxième portion P2.

La première portion P1 est cylindrique. En d'autres termes, la première portion P1 présente une forme de cylindre.

On appelle cylindre le solide délimité par deux plans strictement parallèles et par une surface définie par une droite, appelée génératrice, passant par un point variable décrivant une courbe, appelée courbe directrice et gardant une direction fixe. Si les plans sont perpendiculaires à la droite génératrice, on dit que le cylindre est droit.

La génératrice de la première portion P1 est parallèle à la direction d'empilement Z. Les plans sont perpendiculaires à la direction d'empilement Z. La courbe directrice de la première portion P1 est, par exemple, circulaire. En variante, la courbe directrice de la première portion P1 est polygonale.

La première portion P1 est délimitée selon la direction d'empilement Z par la couche de transition C3, par la couche de passivation C7 et par la première électrode 25. En particulier, la première portion P1 est connectée électriquement à la couche de transition C3 et à la première électrode 25.

La première portion P1 est configurée pour être traversée selon la direction d'empilement Z par les porteurs de charge minoritaires dans la couche absorbante C1.

La première portion P1 présente un dopage du deuxième type. La première portion P1 présente une quatrième densité volumique de dopants d4.

La quatrième densité volumique de dopants d4 est strictement supérieure à la troisième densité volumique de dopants d3. Par exemple, la quatrième densité volumique de dopants d4 est comprise entre 10¹⁵ atomes/cm³ et 10¹⁹ atomes/cm³.

Par exemple, la troisième densité volumique de dopants d3 est comprise entre un centième de la quatrième densité volumique de dopants d4 et un dixième de la quatrième densité volumique de dopants d4 lorsque la quatrième densité volumique de dopants d4 est comprise entre 5.10¹⁷ atomes/cm³ et 10¹⁹ atomes/cm³.

La deuxième portion P2 entoure la première portion P1 dans un plan perpendiculaire à la direction d'empilement Z. En particulier, la deuxième portion P2 sépare la première portion P1 des autres premières portions P1 de l'imageur 10.

La deuxième portion P2 est commune à tous les éléments détecteurs 15 de l'imageur 10.

La deuxième portion P2 est délimitée selon la direction d'empilement Z par la couche de transition C3 et par la couche de passivation C7.

La seconde portion P2 est configurée pour ne pas être traversée selon la direction d'empilement Z par les porteurs de charge minoritaires dans la couche absorbante C1.

La deuxième portion P2 présente un dopage du premier type. La deuxième portion P2 présente une densité volumique de dopants comprise entre 10¹⁴ atomes/cm³ et 10¹⁸ atomes/cm³.

La première portion P1 et la deuxième portion P2 sont, par exemple, réalisées par insertion locale dans une couche présentant le premier type de dopage d'atomes causant un dopage du deuxième type. Ainsi, les portions de la couche dans laquelle aucun atome n'est inséré présentent le premier type de dopage et forment la deuxième portion P2. Les portions de la couche dans lesquelles les atomes ont été insérés présentent alors le deuxième type de dopage et forment la première portion P1. Les atomes sont insérés par implantation ionique ou par diffusion.

La deuxième couche fenêtre C5 est transparente au rayonnement IR.

La deuxième couche fenêtre C5 est commune à tous les éléments détecteurs 15 de l'imageur 10.

La deuxième couche fenêtre C5 forme, par exemple, un substrat pour les autres couches de l'empilement 20.

La deuxième couche fenêtre C5 est configurée pour transmettre un courant électrique entre la deuxième couche intermédiaire C6 et la deuxième électrode.

La deuxième couche fenêtre C5 est délimitée, selon la direction d'empilement Z, par la deuxième couche intermédiaire C6.

La deuxième couche fenêtre C5 est réalisée en un cinquième matériau M5.

Le cinquième matériau M5 est un matériau semi-conducteur. Le cinquième matériau M5 présente une cinquième valeur de gap G5.

La cinquième valeur de gap G5 est supérieure strictement à la première valeur de gap G1.

Le cinquième matériau M5 est un alliage d'éléments des colonnes IIIa et Va du tableau périodique des éléments. Par exemple, le cinquième matériau M5 est l'antimoniure de gallium GaSb.

Le cinquième matériau M5 présente un dopage du premier type.

La deuxième couche fenêtre C5 est planaire. La deuxième couche fenêtre C5 est perpendiculaire à la direction d'empilement Z.

La deuxième couche fenêtre C5 présente une cinquième épaisseur e5. La cinquième épaisseur e5 est comprise entre 50 nm et 100 µm.

La couche intermédiaire C6 est transparente au rayonnement IR.

La couche intermédiaire C6 est commune à tous les éléments détecteurs 15 de l'imageur 10.

La couche intermédiaire C6 sépare la couche absorbante C1 de la deuxième couche fenêtre C5 selon la direction d'empilement Z. En particulier, la deuxième couche intermédiaire C6 est délimitée, selon la direction d'empilement Z, par la couche absorbante C1 et par la deuxième couche fenêtre C5.

La couche intermédiaire C6 est réalisée en un sixième matériau M6.

Le sixième matériau M6 est un matériau semi-conducteur. Le sixième matériau M6 présente une sixième valeur de gap G6.

La sixième valeur de gap G6 est supérieure ou égale à la première valeur de gap G1. Par exemple, la sixième valeur de gap G6 est strictement supérieure à la première valeur de gap G1.

La sixième valeur de gap G6 est inférieure ou égale à la cinquième valeur de gap G5, par exemple strictement inférieure.

Le sixième matériau M6 est un matériau à base d'éléments des colonnes IIIa et Va du tableau périodique des éléments.

Le sixième matériau M6 est un matériau ternaire ou un matériau quaternaire. Quand le sixième matériau M6 est un matériau quaternaire, le sixième matériau M6 est constitué d'éléments constituant également le premier matériau M1. Par exemple, lorsque le premier matériau M1 est InAsSb, le sixième matériau M6 est InAlAsSb. En variante, le sixième matériau M6 est InGaAsSb. En variante, le sixième matériau M6 peut présenter un gradient de composition le long de la direction Z.

La couche intermédiaire C6 présente un dopage du premier type.

Une sixième densité volumique de dopants d6 est définie pour la couche intermédiaire C6. La sixième densité volumique de dopants d6 est strictement supérieure à la deuxième densité volumique de dopants d2.

La couche intermédiaire C6 est planaire. La couche intermédiaire C6 est perpendiculaire à la direction d'empilement Z.

La couche intermédiaire C6 présente une sixième épaisseur e6. La sixième épaisseur e6 est comprise entre 20 nm et 1 µm.

La couche intermédiaire C6 forme une interface de type II avec la couche absorbante C1.

La couche de passivation C7 est transparente au rayonnement IR.

La couche de passivation C7 est commune à tous les éléments détecteurs 15 de l'imageur 10.

La couche de passivation C7 est configurée pour isoler électriquement la première couche fenêtre C1 de l'extérieur de l'empilement 20.

La couche de passivation C7 est réalisée en un huitième matériau M8.

Le huitième matériau M8 est électriquement isolant. Par exemple, le huitième matériau M8 est un matériau diélectrique tel que l'oxyde de silicium SiO₂ ou le nitrure de silicium Si₃N₄.

La couche de passivation C7 est prévue pour empêcher la première couche fenêtre C4 d'être modifiée par une réaction chimique avec l'atmosphère. Par exemple, la couche de passivation C7 est prévue pour empêcher la première couche fenêtre C4 d'être oxydée par l'air ambiant.

La première électrode 25 est en contact électrique avec la première portion P1.

La première électrode 25 traverse la couche de passivation C7 selon la direction d'empilement.

La deuxième électrode est en contact électrique avec la deuxième couche fenêtre C5

Le circuit de lecture est configuré pour recevoir le signal électrique S de chaque élément détecteur 15 et pour générer une image Im à partir de chaque signal électrique S.

Le fonctionnement de l'imageur 10 est maintenant décrit.

Une différence de potentiel est appliquée par le circuit de lecture entre la première électrode 25 et la deuxième électrode de chaque élément détecteur 15.

Lorsque le rayonnement IR illumine un élément détecteur 15, le rayonnement IR est absorbé dans la couche absorbante C1.

L'absorption du rayonnement IR dans la couche absorbante C1 génère une paire électron-trou (également appelée exciton).

La séparation de la paire électron-trou donne naissance au signal électrique S. Le signal électrique S est un courant électrique.

Un tel mode de fonctionnement pour l'élément détecteur 15 est dénommé « mode photovoltaïque ».

Le signal électrique S traverse successivement la deuxième électrode, la deuxième couche fenêtre C5, la couche intermédiaire C6, la couche absorbante C1, la couche de charges écran C2, la couche de transition C3, la première couche fenêtre C4 et la première électrode 25 selon la direction d'empilement Z.

Le signal électrique S est détecté par le circuit de lecture à travers la première électrode 25.

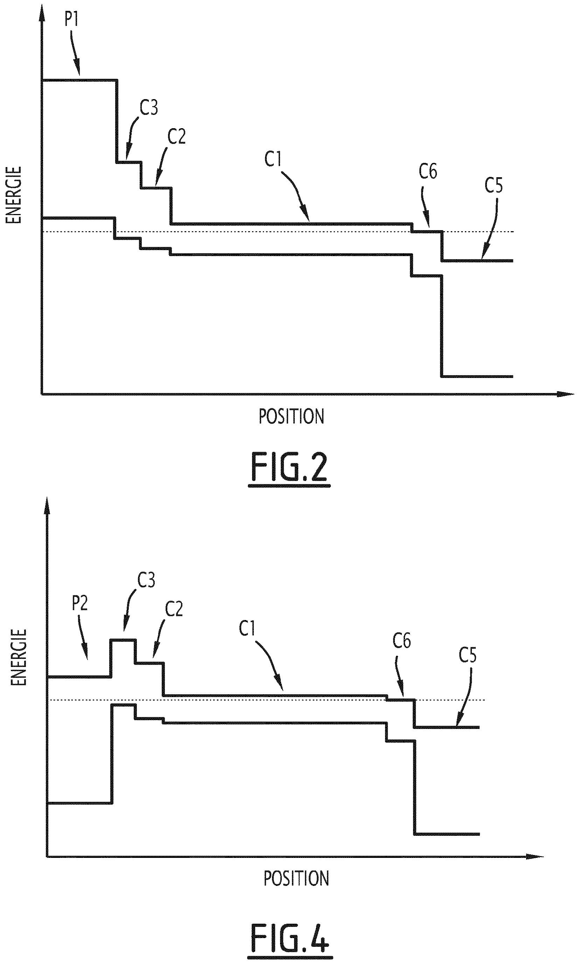

Un diagramme de bandes présentant les niveaux d'énergie de la bande de valence et de la bande de conduction d'un élément détecteur 15 en fonction de la position selon la ligne II-II de la figure 1, qui traverse la première portion P1, a été représenté sur la figure 2. Le diagramme de la figure 2 est un diagramme de principe dans lequel les niveaux d'énergie sont considérés comme uniformes dans les différents matériaux et les effets d'interfaces et de charge d'espace ne sont pas considérés afin de faciliter la comparaison des différentes valeurs de gap G1 à G6.

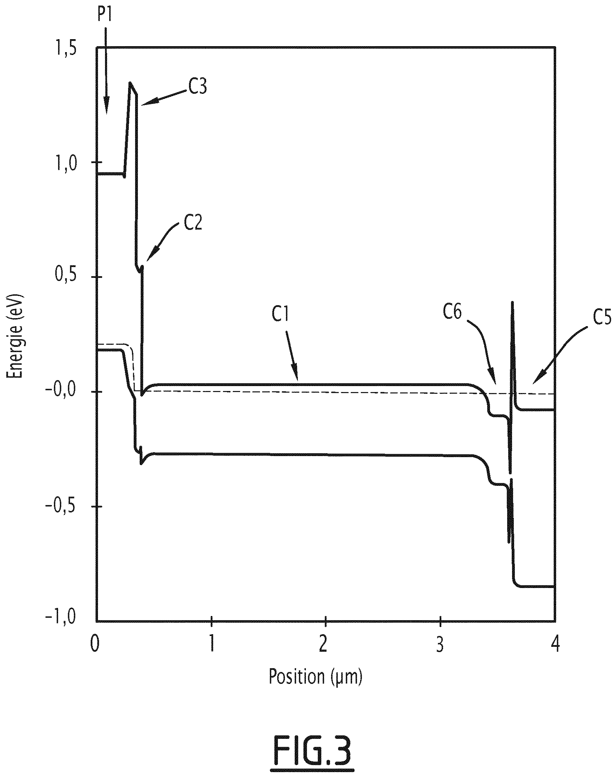

La figure 3 présente un diagramme des bandes d'énergie pris selon la ligne II-II, obtenu par simulation numérique et prenant en compte les effets non pris en compte par le diagramme de la figure 2.

Sur les figures 2 à 5, le niveau de Fermi a été représenté par une ligne discontinue, la bande de conduction et la bande de valence par des lignes continues.

La structure de bandes ne présente pas de barrière susceptible de s'opposer au mouvement des trous depuis la couche absorbante C1 jusqu'à la première électrode 25.

La structure de bandes ne présente pas de barrière susceptible de s'opposer au mouvement des électrons depuis la couche absorbante C1 jusqu'à la deuxième électrode.

Un diagramme de bandes présentant les niveaux d'énergie de la bande de valence et de la bande de conduction d'un élément détecteur 15 en fonction de la position selon la ligne III-III de la figure 1, qui traverse la deuxième portion P2, a été représenté sur la figure 4. Le diagramme de la figure 4 est un diagramme de principe dans lequel les niveaux d'énergie sont considérés comme uniformes dans les différents matériaux et les effets d'interfaces et de charge d'espace ne sont pas considérés afin de faciliter la comparaison des différentes valeurs de gap G1 à G6.

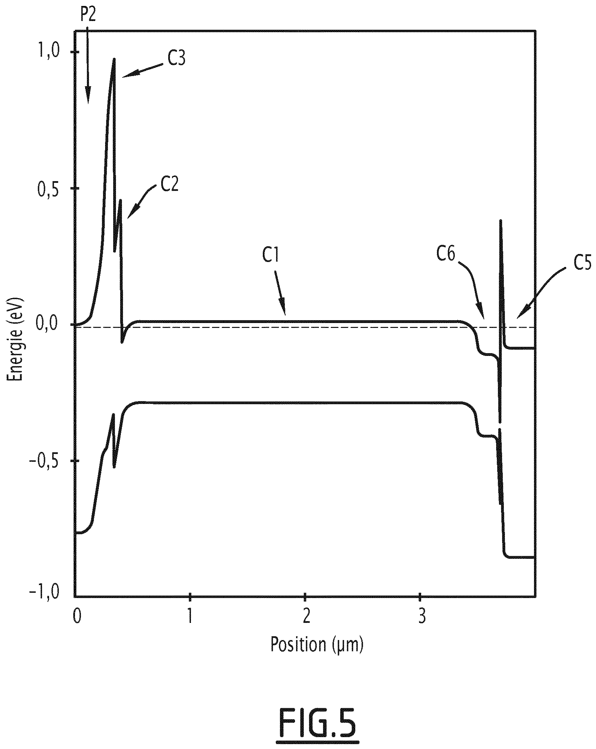

La figure 5 présente un diagramme des bandes d'énergie pris selon la ligne III-III, obtenu par simulation numérique et prenant en compte les effets non pris en compte par le diagramme de la figure 4.

La structure de bandes confine alors les porteurs des deux types dans la couche absorbante C1.

La couche de charges écran C2 et la couche de transition C3 permettent de diminuer le champ électrique dans la couche absorbante C1. La zone de déplétion qui existe à l'interface entre deux couches présentant des dopages de type différent est confinée à la couche de charges écran C2 et à la couche de transition C3. En particulier, la couche absorbante C1 ne présente pas de zone de déplétion.

Ainsi, la couche absorbante C1 présente une bande plate. Les courants d'obscurité causés par des mécanismes de génération-recombinaison sont donc limités, comme expliqué dans un article de G. Marre et al. paru dans la revue « Semiconductor Science and Technology » n°18, page 284 en 2002.

L'imageur 10 présente donc une meilleure sensibilité que les imageurs de l'état de la technique, à température égale. L'imageur 10 peut également être utilisé à une température de fonctionnement supérieure aux imageurs de l'état de la technique, à sensibilité égale.

Grâce à la présence de la couche de transition C3, la structure ne présente pas de barrière ni de discontinuité forte pouvant pénaliser la diffusion des porteurs minoritaires. La sensibilité de l'imageur 10 est donc, là encore, améliorée.

Le premier exemple a été décrit précédemment dans le cas particulier dans lequel les matériaux semi-conducteurs utilisés sont des matériaux massifs en semi-conducteurs III-V. L'homme du métier comprendra aisément que d'autres types de matériaux semi-conducteurs sont susceptibles d'être utilisés. Par exemple, les matériaux utilisés sont des matériaux II-VI, ou encore des semi-conducteurs nitrures dans lesquels les atomes de la colonne Va sont des atomes d'azote.

En variante, au moins un matériau semi-conducteur est un super-réseau. En physique des semi-conducteurs, un super-réseau est un empilement périodique de couches de faibles épaisseurs, typiquement plusieurs nanomètres. Si les couches sont suffisamment fines pour qu'un confinement quantique des porteurs ait lieu dans les couches, un couplage quantique entre les différentes couches cause l'apparition de « mini-bandes » d'énergie. Les énergies de ces mini-bandes sont alors dépendantes de l'épaisseur et de la composition des couches utilisées. Par exemple, le super-réseau InAs/GaSb a été principalement étudié pour la détection infrarouge.

Selon une autre variante, le premier type de dopage est le dopage de type p et le deuxième type de dopage est le dopage de type n.

Les différents exemples et variantes présentés précédemment peuvent être combinés entre eux pour former de nouveaux modes de réalisation.

## Revendications

1. Détecteur (15) de rayonnement comprenant un empilement (20) de couches superposées, l'empilement (20) comprenant successivement le long d'une direction d'empilement (Z):
- une couche absorbante (C1) configurée pour absorber le rayonnement et réalisée en un premier matériau semi-conducteur (M1) présentant une première valeur de gap (G1),
- une couche de charges écran (C2) réalisée en un deuxième matériau semi-conducteur (M2) présentant une deuxième valeur de gap (G2), la deuxième valeur de gap (G2) étant strictement supérieure à la première valeur de gap (G1),
- une couche de transition (C3) réalisée en un troisième matériau semi-conducteur (M3) présentant une troisième valeur de gap (G3), la troisième valeur de gap (G3) étant strictement supérieure à la première valeur de gap (G1), et
- une première couche fenêtre (C4) réalisée en un quatrième matériau semi-conducteur (M4) présentant une quatrième valeur de gap (G4), la quatrième valeur de gap (G4) étant strictement supérieure à la première valeur de gap (G1),
la couche absorbante (C1) et la couche de charges écran (C2) présentant chacune un dopage d'un premier type, la première couche fenêtre (C4) présentant un dopage d'un deuxième type différent du premier type, la couche de transition (C3) présentant un dopage du premier type ou un dopage du deuxième type, une densité volumique de dopants étant définie pour chacune de la première couche fenêtre (C4) et de la couche de transition (C3), la densité volumique de dopants (d4) de la couche fenêtre (C4) étant strictement supérieure à la densité volumique de dopants (d3) de la couche de transition (C3), le premier matériau (M1) et le deuxième matériau (M2) étant choisis pour que la couche absorbante (C1) et la couche de charges écran (C2) :
- forment une interface de type II, ou
- ne présentent pas de barrière d'énergie à un mouvement depuis la couche absorbante (C1) jusqu'à la couche de charges écran (C2) des porteurs de charge minoritaires dans la couche absorbante (C1) ;
le deuxième matériau (M2) et le troisième matériau (M3) étant choisis pour que la couche de charges écran (C2) et la couche de transition (C3) :
- forment une interface de type II, ou
- ne présentent pas de barrière d'énergie à un mouvement depuis la couche de charges écran (C2) jusqu'à la couche de transition (C3) des porteurs de charge minoritaires dans la couche absorbante (C1).

2. Détecteur (15) de rayonnement selon la revendication 1, dans lequel la couche de transition (C3) présente un dopage du deuxième type.

3. Détecteur (15) de rayonnement selon la revendication 1 ou 2, dans lequel une densité volumique de dopants (d1) est définie pour chacune de la couche absorbante (C1) et de la couche de charges écran (C2), la densité volumique de dopants (d1) de la couche absorbante (C1) étant strictement inférieure à la densité volumique de dopants (d2) de la couche de charges écran (C2).

4. Détecteur (15) de rayonnement selon l'une quelconque des revendications 1 à 3, dans lequel la deuxième densité volumique de dopants (d2) est comprise entre 10¹⁶ et 10¹⁷ atomes par centimètres cube.

5. Détecteur (15) de rayonnement selon l'une quelconque des revendications 1 à 4, dans lequel l'empilement (20) comprend en outre :
- une deuxième couche fenêtre (C5) réalisée en un cinquième matériau semi-conducteur (M5) présentant une cinquième valeur de gap (G5) et
- une couche intermédiaire (C6) réalisée en un sixième matériau semi-conducteur (M6) présentant une sixième valeur de gap (G6),
la couche absorbante (C1) étant délimitée selon la direction d'empilement (Z) par la couche de charges écran (C2) et la couche intermédiaire (C6), la couche intermédiaire (C2) étant délimitée selon la direction d'empilement (Z) par la couche absorbante (C1) et par la deuxième couche fenêtre (C5), la cinquième valeur de gap (G5) étant strictement supérieure à la première valeur de gap (G1) et la sixième valeur de gap (G6) étant comprise entre la cinquième valeur de gap (G5) et la première valeur de gap (G1).

6. Détecteur (15) de rayonnement selon la revendication 5, dans lequel la couche intermédiaire (C6) présente un dopage du premier type, une densité volumique de dopants (d6) étant définie pour la couche intermédiaire (C6), la densité volumique de dopants de la couche intermédiaire (C6) étant supérieure ou égale à la densité volumique de dopants de la couche absorbante (C1).

7. Détecteur (15) de rayonnement selon l'une quelconque des revendications 1 à 6, dans lequel le premier matériau (M1), le deuxième matériau (M2), le troisième matériau (M3) et le quatrième matériau (M4) sont des matériaux semi-conducteurs à base d'éléments des colonnes IIIA et VA du tableau périodique des éléments.

8. Détecteur (15) de rayonnement selon l'une quelconque des revendications 1 à 7, dans lequel la première couche fenêtre (C4) comporte une première portion (P1) présentant un dopage du deuxième type et au moins une deuxième portion (P2) présentant un dopage du premier type, la deuxième portion (P2) séparant chaque première portion (P1) de chaque autre première portion (P1) et chaque première portion (P1) étant entourée par la deuxième portion (P2) dans un plan perpendiculaire à la direction d'empilement (Z).

## Patentansprüche

1. Strahlungsdetektor (15), der einen Stapel (20) von übereinander liegenden Schichten umfasst, wobei der Stapel (20) aufeinanderfolgend entlang einer Stapelrichtung (Z) umfasst:
- eine absorbierende Schicht (C1), die zum Absorbieren der Strahlung ausgebildet ist und in einem ersten Halbleitermaterial (M1) hergestellt ist, das einen ersten Bandlückenwert (G1) aufweist,
- eine Abschirm-Ladungsschicht (C2), die aus einem zweiten Halbleitermaterial (M2) hergestellt ist, das einen zweiten Bandlückenwert (G2) aufweist, wobei der zweite Bandlückenwert (G2) streng größer als der erste Bandlückenwert (G1) ist,
- eine Übergangsschicht (C3), die aus einem dritten Halbleitermaterial (M3) hergestellt ist, das einen dritten Bandlückenwert (G3) aufweist, wobei der dritte Bandlückenwert (G3) streng größer als der erste Bandlückenwert (G1) ist, und
- eine erste Fensterschicht (C4), die aus einem vierten Halbleitermaterial (M4) hergestellt ist, das einen vierten Bandlückenwert (G4) aufweist, wobei der vierte Bandlückenwert (G4) streng größer als der erste Bandlückenwert (G1) ist,
wobei die absorbierende Schicht (C1) und die Abschirm-Ladungsschicht jeweils eine Dotierung eines ersten Typs aufweisen, die erste Fensterschicht (C4) eine Dotierung eines zweiten Typs unterschiedlich zum ersten Typ aufweist, die Übergangsschicht (C3) eine Dotierung des ersten Typs oder eine Dotierung des zweiten Typs aufweist, wobei eine Volumendichte an Dotierstoffen für jede der ersten Fensterschicht (C4) und der Übergangsschicht (C3) definiert ist, wobei die Volumendichte an Dotierstoffen (d4) der Fensterschicht (C4) streng größer ist als die Volumendichte an Dotierstoffen (d3) der Übergangsschicht (C3), wobei das erste Material (M1) und das zweite Material (M2) ausgewählt ist, damit die absorbierende Schicht (C1) und die Abschirm-Ladungsschicht (C2):
- eine Grenzschicht des Typs II bilden, oder
- keine Energiesperre für eine Bewegung der MinoritätsLadungsträger in der absorbierenden Schicht (C1) von der absorbierenden Schicht (C1) zur Abschirm-Ladungsschicht (C2) darstellen;
das zweite Material (M2) und das dritte Material (M3) ausgewählt sind, damit die Abschirm-Ladungsschicht (C2) und die Übergangsschicht (C3):
- eine Grenzschicht des Typs II bilden, oder
- keine Energiesperre für eine Bewegung der MinoritätsLadungsträger in der absorbierenden Schicht (C1) von der Abschirm-Ladungsschicht (C2) zur Übergangsschicht (C3) darstellen.

2. Strahlungsdetektor (15) nach Anspruch 1, bei dem die Übergangsschicht (C3) eine Dotierung des zweiten Typs aufweist.

3. Strahlungsdetektor (15) nach Anspruch 1 oder 2, bei dem eine Volumendichte an Dotierstoffen (d1) für jede der absorbierenden Schicht (C1) und der Abschirm-Ladungsschicht definiert ist, wobei die Volumendichte an Dotierstoffen (d1) der absorbierenden Schicht (C1) streng kleiner als die Volumendichte an Dotierstoffen (d2) der Abschirm-Ladungsschicht (C2) ist.

4. Strahlungsdetektor (15) nach einem beliebigen der Ansprüche 1 bis 3, bei dem die zweite Volumendichte an Dotierstoffen (d2) zwischen 10¹⁶ und 10¹⁷ Atomen pro Kubikzentimeter liegt.

5. Strahlungsdetektor (15) nach einem beliebigen der Ansprüche 1 bis 4, bei dem der Stapel (20) außerdem umfasst:
- eine zweite Fensterschicht (C5) die aus einem fünften Halbleitermaterial (M5) hergestellt ist, das einen fünften Bandlückenwert (G5) aufweist, und
- eine Zwischenschicht (C6), die aus einem sechsten Halbleitermaterial (M6) hergestellt ist, das einen sechsten Bandlückenwert (G6) aufweist,
wobei die absorbierende Schicht (C1) gemäß der Stapelrichtung (Z) durch die Abschirm-Ladungsschicht (C2) und die Zwischenschicht (C6) begrenzt ist, wobei die Zwischenschicht (C2) gemäß der Stapelrichtung (Z) durch die absorbierende Schicht (C1) und die zweite Fensterschicht (C5) begrenzt ist, wobei der fünfte Bandlückenwert (G5) streng größer als der erste Bandlückenwert (G1) ist und der sechste Bandlückenwert (G6) zwischen dem fünften Bandlückenwert (G5) und dem ersten Bandlückenwert (G1) liegt.

6. Strahlungsdetektor (15) nach Anspruch 5, bei dem die Zwischenschicht (C6) eine Dotierung des ersten Typs aufweist, wobei eine Volumendichte an Dotierstoffen (d6) durch die zweiten Schicht (C6) definiert ist, wobei die Volumendichte an Dotierstoffen der Zwischenschicht (C6) größer oder gleich der Volumendichte an Dotierstoffen der absorbierenden Schicht (C1) ist.

7. Strahlungsdetektor (15) nach einem beliebigen der Ansprüche 1 bis 6, bei dem das erste Material (M1), das zweite Material (M2), das dritte Material (M3) und das vierte Material (M4) Halbleitermaterialien auf Basis der Elemente der Spalten IIIA und VA der Tabelle des Periodensystems der Elemente sind.

8. Strahlungsdetektor (15) nach einem beliebigen der Ansprüche 1 bis 7, bei dem die erste Fensterschicht (C4) einen ersten Bereich (P1) umfasst, der eine Dotierung des zweiten Typs aufweist, und mindestens einen zweiten Bereich (P2) umfasst, der eine Dotierung des ersten Typs aufweist, wobei der zweite Bereich (P2) jeden ersten Bereich (P1) von jedem anderen ersten Bereich (P1) trennt und jeder erste Bereich (P1) von dem zweiten Bereich (P2) in einer Ebene senkrecht zur Stapelrichtung (Z) umgeben ist.

## Claims

1. A radiation detector (15) comprising a stack (20) of superimposed layers, the stack (20) successively comprising, in a stacking direction (Z):
- an absorbent layer (C1) configured to absorb the radiation and made from a first semiconductor material (M1) having a first bandgap value (G1),
- a screen charges layer (C2) made from a second semiconductor material (M2) having a second bandgap value (G2), the second bandgap value (G2) being strictly greater than the first bandgap value (G1),
- a transition layer (C3) made from a third semiconductor material (M3) having a third bandgap value (G3), the third bandgap value (G3) being strictly greater than the first bandgap value (G1), and
- a first window layer (C4) made from a fourth semiconductor material (M4) having a fourth bandgap value (G4), the fourth bandgap value (G4) being strictly greater than the first bandgap value (G1),
the absorbent layer (C1) and the screen charges layer (C2) each having a doping of a first type, the first window layer (C4) having a doping of a second type different from the first type, the transition layer (C3) having a doping of the first type or a doping of the second type, a density of dopants being defined for each of the first window layer (C4) and the transition layer (C3), the density of dopants (d4) of the window layer (C4) being strictly greater than the density of dopants (d3) of the transition layer (C3), the first material (M1) and the second material (M2) being chosen so that the absorbent layer (C1) and the screen charges layer (C2):
- form a type II interface, or
- have no energy barrier to a movement from the absorbent layer (C1) to the screen charges layer (C2) of the minority charge carriers in the absorbent layer (C1);
the second material (M2) and the third material (M3) being chosen so that the screen charges layer (C2) and the transition layer (C3):
- form a type II interface, or
- have no energy barrier to a movement from the screen charges layer (C2) to the transition layer (C3) of the minority charge carriers in the absorbent layer (C1).

2. The radiation detector (15) according to claim 1, wherein the transition layer (C3) has a doping of the second type.

3. The radiation detector according to claim 1 or 2, wherein a density of dopants (d1) is defined for each of the absorbent layer (C1) and the screen charges layer (C2), the density of dopants (d1) of the absorbent layer (C1) being strictly less than the density of dopants (d2) of the screen charges layer (C2).

4. The radiation detector (15) according to any one of claims 1 to 3, wherein the second dopant density (d2) is between 10¹⁶ and 10¹⁷ atoms per cubic centimeter.

5. The radiation detector (15) according to any one of claims 1 to 4, wherein the stack (20) further comprises:
- a second window layer (C5) made from a fifth semiconductor material (M5) having a fifth bandgap value (G5), and
- an intermediate layer (C6) made from a sixth semiconductor material (M6) having a sixth bandgap value (G6),
the absorbent layer (C1) being delimited in the stacking direction (Z) by the screen charges layer (C2) and the intermediate layer (C6), the intermediate layer (C2) being delimited in the stacking direction (Z) by the absorbent layer (C1) and the second window layer (C5), the fifth bandgap value (G5) being strictly greater than the first bandgap value (G1) and the sixth bandgap value (G6) being comprised between the fifth bandgap value (G5) and the first bandgap value (G1).

6. The radiation detector (15) according to claim 5, wherein the intermediate layer (C6) has a doping of the first type, a dopant density (d6) being defined for the intermediate layer (C6), the density of dopants of the intermediate layer (C6) being greater than or equal to the density of dopants of the absorbent layer (C1).

7. The radiation detector (15) according to any one of claims 1 to 6, wherein the first material (M1), the second material (M2), the third material (M3) and the fourth material (M4) are semiconductor materials with a base of elements from columns IIIA and VA of the periodic table of elements.

8. The radiation detector (15) according to any one of claims 1 to 7, wherein the first window layer (C4) includes a first portion (P1) having a doping of the second type and at least one second portion (P2) having a doping of the first type, the second portion (P2) separating each first portion (P1) from each other first portion (P1) and each first portion (P1) being surrounded by the second portion (P2) in a plane perpendicular to the stacking direction (Z).
